# EUROPEAN PATENT APPLICATION

(11) **EP 2 457 719 A1**
(43) Date of publication of application: **30.05.2012**
(21) Application number: 10192458.7
(22) Date of filing: 24.11.2010
(51) Int. Cl.: B29C 67/00

(54) **Interconnect structure and method for producing same**

(71) Applicant: Nederlandse Organisatie voor toegepast- natuurwetenschappelijk onderzoek TNO, 2628 VK Delft (NL)
(72) Inventor: Oosterhuis, Gerrit, 2628 VK Delft (NL); Maalderink, Herman Hendrikus, 2628 VK Delft (NL); Rijfers, Andries, 2628 VK Delft (NL); Houben, René Jos, 2628 VK Delft (NL); van der Zon, Clemens Maria Bernardus, 2628 VK Delft (NL); Brouwers, leonardus Antonius Maria, 2628 VK Delft (NL)
(74) Representative: Jansen, Cornelis Marinus

(57) **Abstract**

There is provided a three-dimensional interconnect structure for microelectronic devices and a method for producing such an interconnect structure. The method comprises a step wherein a backbone structure 100 is manufactured using an additive layer-wise manufacturing process 310. The backbone structure 100 comprises a three-dimensional cladding skeleton 104 and a support structure 101. The cladding skeleton comprises layered freeform skeleton parts 105 that will form the electric interconnections between the electric contacts of the interconnect structure after a conductive material 202 is applied on the backbone structure 100. The support structure 101 supports the layered freeform skeleton parts 105. Parts 306 of the support structure 101 may be removed to isolate and/or expose the electric interconnections 205. The cladding skeleton can be embedded by an insulating material 303 for providing a further support.

## Description

### FIELD AND BACKGROUND OF THE INVENTION

The invention generally relates to the field of interconnect structures, in particular to an improved three-dimensional integrated interconnect structure for micro-electronic devices and a method for producing such an interconnect structure.

An interconnect structure, also referred to as 'interposer', is an electrical interface routing between one socket or connection to another. In the semiconductor industry interposers are conventionally used to support, interconnect and/or generally operate micro-electronic devices such as semiconductor chips or other circuits. A semiconductor chip is an electronic circuit built on a semiconductor substrate, usually one of single-crystal silicon. The circuit, often called a chip, may be of a bare die type, or is packaged in a sealed case or plastic capsule, with leads or contacts extending from the chip e.g. for input, output, power-supply or other connections (e.g. to an interposer) that may be necessary when the device is in use. Besides semiconductor chips also other micro-electronic devices can be interconnected by the interposer including circuits or components comprising input and/or output connections for the interconnect structure.

Conventionally an interposer for semiconductor chips or other microelectronic devices is created e.g. on a silicon substrate through lithographic techniques, typically involving various masks and/or subtractive techniques such as etching steps. It is desirable to create interconnecting circuitry without such time consuming steps.

It is known in the art to create structures using additive and/or maskless techniques. For example JP8244138, US2006237879, W02008063069, DE19648080, JP10012995, W02008806494 show layer-wise additive manufacturing processes known as Layered Manufacturing (LM), also referred to as Rapid Prototyping (RP) or Rapid Manufacturing (RM). These techniques are called "rapid" because they do not require a mould or mask to be designed or manufactured. They thus provide advantages of low start-up costs particularly useful for specialized or small batches.

In a layer-wise additive manufacturing process a tangible object is created layer by layer wherein each layer corresponds to a pattern of a layer of the object. For example a layer may comprise a radiation curable liquid and the pattern is applied e.g. by a digital light projection (DLP) system. Alternatively e.g. a printing apparatus is used to print the layers one on top of the other or a number of foils are used to create a layered structure.

In such a way it is possible to create structures with microscopic length scales, e.g. corresponding to length scales that are desired for the creation of interposers (e.g. 5 - 100 micrometers). Unfortunately the technique is limited by the materials that can be used to create the objects, e.g. a material comprises a radiation curable substance such as a resin. In particular it is currently not feasible with a layer-wise additive manufacturing process to directly create an interposer with interconnections that can function as electric conduits to interconnect semiconductor chips or other micro-electronic devices.

JP8244138 discloses a method of using an optical molding process for forming a base plate by curing an optically curing resin. The base plate comprises a number of vertical tunnels through the plate and troughs along the surface of the plate. The molding process is followed by an electroless plating process for forming a conductive layer in the tunnels and troughs of the base plate thus forming the circuit. Disadvantageously, the circuitry that can thus be created is still limited. The currently known processes not only limit the shape, length, and layout of the interconnections but also the dimensions of the interposer.

There is a need for an interposer that can keep up with the trend of ever smaller chips dimensions and connections, an interposer that can be rapidly manufactured with a custom desired layout. There is a further need for a rapid manufacturing or prototyping process to create interposers with smaller interconnection, a method for creating interposers with more flexibility in the choice of the layout of the contact positions and conductive tracks. There is a further need for more flexibility in the dimensions of the interposer and the positions for connecting semi-conductor chips in various relative orientations.

### SUMMARY OF THE INVENTION

In a first aspect there is provided a method for producing a three-dimensional interconnect structure comprising one or more electric interconnections ending in externally addressable electric contacts on one or more connection faces of the interconnect structure for electrically interconnecting micro-electronic devices connected to said one or more connection faces. The method comprises the steps of
- constructing through an additive layer-wise manufacturing process a backbone structure comprising
   o a three-dimensional cladding skeleton comprising layered freeform skeleton parts forming freeform interconnections between corresponding contacts , said contacts arranged in the connection faces; and
   o a connected support structure of layered support parts that support and connect the cladding skeleton parts;
- cladding the cladding skeleton structure with a conductive cladding material; and
- electrically disconnecting cladded skeleton parts from each other thereby creating electric interconnections of the interconnect structure along the cladded skeleton parts between the corresponding contacts.

An advantage of the currently proposed method is an increased flexibility in the design of the conductive pathways. It is now possible to create truly three-dimensional intertwined pathways that follow almost any desired trajectory not bound in direction by the orientation of the faces, e.g. known interposers have only pathways along the faces of the structure and/or pathways vertically/straight through the interposer/plate. To create diagonal pathways known interposers use a stacking of interposers with horizontal and vertical pathways. The currently proposed layered free-form cladding skeleton parts do not require internal interconnections between stacked layers as is traditionally provided in a via structure and can form freeform interconnections between different faces on an interposer and connect microelectronic devices in various relative orientations.

In a second aspect there is provided a three-dimensional interconnect structure comprising
- a connect structure with faces for connecting semiconductor chips connectable to said faces;
- a plurality of electric contacts that are externally addressable on said faces; and
- a plurality of electric interconnections , the electric interconnections ending in two or more of the electric contacts for electrically interconnecting the semiconductor chips, wherein
- the electric interconnections are formed as layered freeform skeleton parts cladded by a conductive material.

Further advantages and areas of applicability of the present systems and methods will become apparent from the detailed description provided hereinafter. It should be understood that the detailed description and specific examples, while indicating exemplary embodiments and methods to its use, are intended for purposes of illustration only and are not intended to limit the scope of the invention.

### BRIEF DESCRIPTION OF THE DRAWINGS

These and other features, aspects, and advantages of the apparatus, systems and methods of the present invention will become better understood from the following description, appended claims, and accompanying drawing where in:
FIG 1 shows two views of an embodiment of a backbone structure;
FIG 2 shows an embodiment of an interposer;
FIG 3 shows a method for creating an externally addressable electric contact by using a dome structure;
FIG 4 shows a view of a protruding dome structure and an electric contact that is created after removing the dome structure;
FIG 5 shows another method for creating an externally addressable electric contact by widening the electric connections near the surface;
FIG 6 shows a schematic example of a layer-wise manufacturing process;
FIG 7 shows another embodiment of an interposer;
FIG 8 shows additional features on an another embodiment of an interposer;
FIG 9 shows two embodiments of protruding arches supporting a cladding skeleton part;
FIG 10 shows two embodiments of internal support parts supporting a cladding skeleton part;
FIG 11 shows two embodiments wherein an interconnection comprises a hollow tube;

### DETAILED DESCRIPTION

The following description of certain exemplary embodiments is merely exemplary in nature and is in no way intended to limit the invention, its application, or uses. In the following detailed description of embodiments of the present systems, devices and methods, reference is made to the accompanying drawings which form a part hereof, and in which are shown by way of illustration specific embodiments in which the described devices and methods may be practiced. These embodiments are described in sufficient detail to enable those skilled in the art to practice the presently disclosed systems and methods, and it is to be understood that other embodiments may be utilized and that structural and logical changes may be made without departing from the spirit and scope of the present system.

The following detailed description is therefore not to be taken in a limiting sense, and the scope of the present system is defined only by the appended claims. Moreover, for the purpose of clarity, detailed descriptions of well-known devices and methods are omitted so as not to obscure the description of the present system.

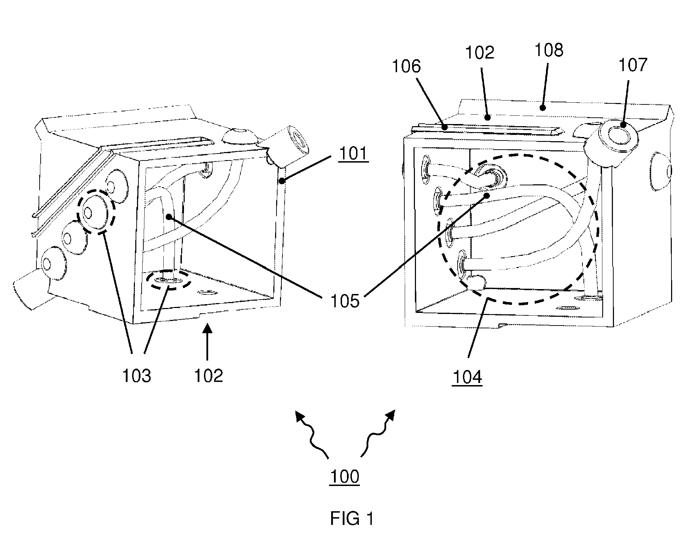

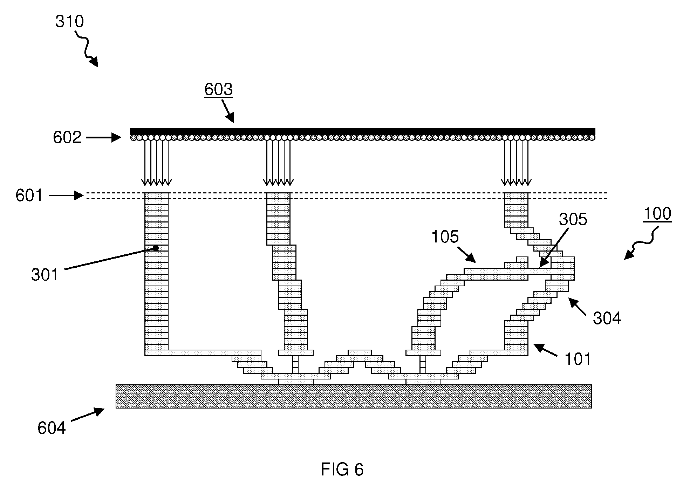

FIG 1 shows two perspectives of an illustrative embodiment of a backbone structure 100. A backbone structure 100 such as depicted here can be manufactured using a layer-wise manufacturing process, e.g. such as known in the art or as illustrated in FIG 6 (by example only). The backbone structure 100 according to the embodiment comprises a cladding skeleton 104 inside a hollow container 101, e.g. a (half open) box. The cladding skeleton 104 comprises layered freeform cladding skeleton parts 105 that form connections between contact positions 103 on several faces 102 of the container 101 and is constructed through an additive layer-wise manufacturing process. Such processes are known in the art known such as SLS, SLA or 3D printing, in an example an additive layer-wise manufacturing process comprises repeatedly the steps of providing a layer of radiation curable liquid; and performing a solidifying step wherein a layer of the backbone structure 100 is formed, the solidifying step carried out by illuminating said layer of radiation curable liquid with a predetermined pattern of radiation corresponding to a pattern of the layer of the backbone structure 100.

Other features of the backbone structure may include an access tube 107 that provides an external access to an inside of the container in case the container would otherwise form a closed structure. A ridge on the backbone structure 100 can function as a support point 108 to hang or support the backbone structure 100 while it is being built in the layer-wise manufacturing process.

In a subsequent cladding (layer application) process the backbone structure 100 including skeleton 104 is wholly or partially cladded by a cladding layer of a conductive material. A partial cladding may prevent undesired electrical connections between skeleton parts 105.

Such cladding or metalizing methods are known in the art, e.g. from JP8244138, and comprise the application of a (thin) layer of (conductive) material on a surface of a structure. The cladding step may include preparatory steps, such as a roughening of the surface and or the application of a seed layer that helps the growth of the conductive layer on the surface of the structure.

In an embodiment, cladding can be performed by the following steps.

The skeleton may be pretreated with an etch solution for a period between 5 and 20 minutes at a temperature typically between 20 and 90 degrees Celsius, to create a rough and wettable surface that will yield good adhesion. The etch solution can be acidic or alkalic, and may contain oxidizing agents.

Then the skeleton is activated by treating it with a solution containing a reducing agent like tin, and a solution containing a palladium catalyst.

The cladding is performed in a solution containing a metal salt, for instance copper or nickel, stabilizers and a reducing agent. Metallization takes between 5 and 30 minutes, depending on the desired metal layer thickness at temperatures between 35 and 90 degrees.

An advantageous method of cladding the non-conductive backbone structure 100 is electroless plating. Electroless plating, also known as chemical or auto-catalytic plating, is a non-galvanic type of plating method that involves reactions in a liquid solution occurring without the use of external electrical power.

After the skeleton structure is cladded, an insulating filler material (not shown in FIG 1) is applied to an inside of the container to give the backbone structure 100, in particular the cladding skeleton 104 further support and e.g. to embed the interconnecting pathways from involuntarily touching each other. Advantageously the insulating material provides an electrical insulation while still allowing thermal or heat conduction, e.g. generated in electric pathways embedded in the insulating material.

The term 'backbone structure 100' is used in this text to refer to the structure that is constructed during the layer-wise manufacturing process, including the cladding skeleton 104, support structure 101, and any other functional features. This backbone structure 100 acts as a 'backbone' for the subsequent cladding and filling steps.

The term 'cladding skeleton 104' is used in this text to indicate a structure that builds skeleton parts for the cladding material used for providing the electric interconnections comprising such as solidified rods or wires or tubes etc. These rods, wires or tubes are referred to as 'cladding skeleton parts 105' and may form connections to the surface of the container 101 ending in externally addressable electric contacts 103 on one or more connection faces 101. In some embodiments, a single connection between two contacts is provided; other embodiments may include multiple connections between more than two contacts. An advantage of a cladding skeleton 104 with solid skeleton parts as opposed to tube form skeleton parts defining an interior pathway through the parts is a better accessibility for the cladding process to the surface of the structure. The cladding skeleton has a substantially outer functional surface while the tube form structure has a substantially inner functional surface.

The term 'support structure 101' is used to indicate substantially all supporting parts of the backbone structure that support the interconnecting skeleton parts between contacts 103. The support structure may include faces (102) forming a container as shown in FIG 1 but also support or connection rods that are used to support the cladding skeleton parts with respect to the container.

The faces 102 of the container of support structure 101 in this embodiment coincide with the 'connection faces 102' in a plane wherein the contact positions 103 are situated, i.e. the face where the micro-electronic devices will be connected. In another embodiment (not shown) the face 102 does not need to be built in the additive manufacturing process but can result e.g. from grinding back an insulating material that is used to embed to cladding skeleton. Nevertheless the contact positions can be situated the connection plane 102.

In an embodiment contact pads can be produced with an indicative pad diameter ranging to values of 30 micrometers or larger less and spaced apart at least 60 micrometers. The wire thickness is > 30 µm

In an embodiment, the cladding step renders the connecting parts of the backbone structure 100 into a completely cladded structure. To create electrical interconnections 205 the conductive cladding on the cladding skeleton parts from the conductive cladding of the rest of the backbone structure 100, e.g. the container 101. In an embodiment the exterior of the cladded backbone structure 100 is etched, grinded or milled away until the conductive material inside the container is removed and the conductive material on the endings of the pathways 105 are isolated and exposed on the exterior faces 102 of the backbone structure 100.

In a further advantageous embodiment, shown in FIG 1, the skeleton parts end in dome shaped structures near contact positions 103, which dome structures can be subsequently removed, e.g. by grinding to isolate the conductive cladding of the skeleton parts 105 from the conductive cladding of the backbone structure 100.

In a further advantageous embodiment, the hollow container comprises an at least partially closed structure with one or more external accesses 107 to the inside of the container. These accesses 107 can act as conduits for flushing or pumping a plating fluid (conductive material) and/or an insulating material. This can be used to selectively apply a conductive layer to the inside of the backbone structure 100 to clad the skeleton 104. This can be advantageous e.g. if it is not desired to clad the entire outside of the structure. Alternatively the whole backbone structure can be cladded e.g. by dipping the backbone structure 100 in a bath of plating fluid.

In a further advantageous embodiment, the container 101 further comprises ridges 106 forming a trough on an outside face 102 of the container. When the backbone structure 100 is plated, the trough can form an electric interconnection on an outside face of the support structure; said trough and ridges 106 are cladded during a cladding step; and said ridges 106 are at least partially removed to isolate the electric interconnection on the outside face of the support structure.

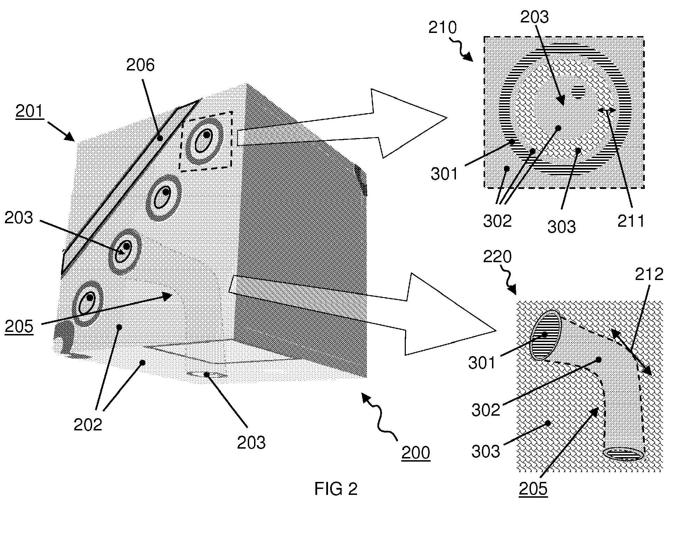

FIG 2 shows an embodiment of an interposer 200 with a detailed view 210 of an electric contact 203 and a detailed (inside) view 220 of an internal electric interconnection 205 (normally not externally visible), both part of the interposer 200. The shown interposer 200 can be obtained after (partially) grinding or milling the faces 102 of a cladded and insulated backbone structure 100 such as shown in FIG 1. The interposer 200 comprises a support structure 201 with two or more faces 202 that correspond to the faces 102 of the backbone structure 100. The faces comprise a plurality of electric contacts 203 that are externally addressable on the faces of the support structure 201. These contacts 203 were created on the corresponding contact positions 103 of the backbone structure 100. The interposer 200 further comprises one or more electric interconnections in or on the support structure (205 and 206, respectively).

The internal interconnections 205 are created from the corresponding cladding skeleton parts 105 and end in two or more contacts 203 thus forming an electric interconnection 205 between these contacts 203. In particular the detailed view 220 (illustrating a view inside the container) shows that the electric interconnection 205 comprises a core of the material 301 that was used in the additive layer-wise manufacturing process that created the backbone structure and is cladded by a conductive material 302 (e.g. a metal such as copper) that was introduced in a cladding step. Furthermore the electric interconnections 205 are embedded in the insulating material 303 added in an insulating step.

The detailed view 220 further illustrates that an electric interconnection 205 can follow a freeform path through the interposer that has over at least a portion of its trajectory a direction 212 that has a curved path connecting the contacts, which may be substantially non-parallel and non-perpendicular with respect to any face 202 of the interposer 200 (i.e. the direction can be anywhere in between parallel and perpendicular such as diagonal, independent of the orientation of the faces) and is not following a design rule imposed by horizontal interconnect planes or vertical via structures. This is one of the aspects that differentiate the currently proposed electric interconnection 205 from electric interconnections that run along the surface of a face of an interposer and/or form (vertical) vias straight through the interposer, perpendicular to the face. This aspect allows for the direct creation of diagonal pathways through the interposer (instead of e.g. a 3D stacking of horizontal and vertical pathways on separate interposers). It also means that the freeform interposer connections can be truly three dimensional and intertwined instead of simply a combination of parallel and perpendicular pathways. A particular advantage over e.g. conductive connections running along the surface of an interposer is that in a 3D structure the conductive connections can be conveniently intertwined and/or cross pathways. A three dimensional cube could provide additional advantages over a flat plate, e.g. in compactness and having possibly shorter signal lines between more than two chips.

In a further advantageous embodiment the support structure 201 has more than two faces comprising electric contacts and/or electric contacts between two faces that are substantially not parallel. This is made possible by the freedom in the pathways of the interconnections. In particular the electric interconnections can go from one face of the interposer to any other face of the interposer, independent of the relative orientation of these faces. This also means that semiconductor chips or other components such as LEDS, receivers, etc. can be attached to multiple faces of an interposer and/or on non-parallel faces of the interposer. This could provide advantages e.g. for the compactness of the design of a 3D integrated circuit where chips can be placed on various sides of a structure instead of only on one or two sides of a flat base plate.

Optionally, an external interconnection is e.g. formed by the conductive track 206 on the surface of the interposer 200 from a pattern of ridges 106 and a trough such as mentioned earlier. The interposer 200 may thus further comprise electric interconnections 206 along a surface of the support structure 201. Such external electric interconnections 206 do not provide the same level of the flexibility as the internal electric connections 205 but may nevertheless be advantageous to form simple (e.g. not intertwined) external connections on a face 202 of the interposer 200 or between faces 202.

In a further detail 210 an illustration is given of an advantageous embodiment of the electric contacts 203 wherein the conductive material on the contact 203 on an outer face 202 of the interposer 200 is insulated from a surrounding conductive material 302 on the interposer 202 by an insulating perimeter 211 of the insulating material 303. Such a perimeter 211 can be obtained e.g. by cutting away a dome structure filled with insulating material 302 near a contact position 103. A remnant of the material 301 from which the dome was constructed in the layer-wise additive manufacturing process is still shown by the ring in the top view of the contact 203 in the detail 210.

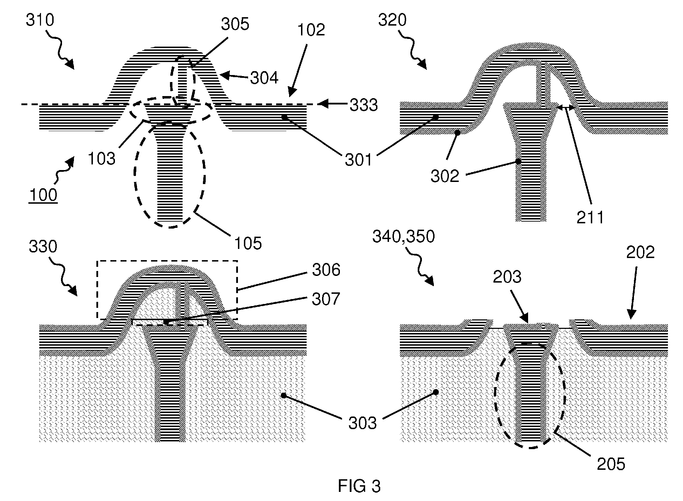

FIG 3 schematically shows a cross-section of a dome structure (such as shown at the contact positions 103 in FIG 1) during various process steps 310, 320, 330, 340, and 350. In particular it illustrates further details of an advantageous method for creating an externally addressable electric contact 203 wherein a part of a conductive material 302 on an electric interconnection is isolated 340 and exposed 350.

In a layer-wise additive manufacturing step 310 using a material 301, a hollow dome structure 304 is created protruding from a face 102 of the container. The ending 103 of a corresponding cladding skeleton part 105 that will form the electric contact 203 lies below or inside this dome 304. To provide the cladding skeleton part 105 with support during this and subsequent steps a support rod 305 can be constructed that connects an ending of the cladding skeleton part 105 with an inside of the hollow dome 304. In another embodiment this support rod can be at only one of the contact points 103 or at a different location between the contact points 103. Advantageously the protruding hollow dome forms a bridging connection over a separation 211 between an ending 103 of a cladding skeleton part 105 and the face 102 of the support structure 101. This separation will later conveniently form an electric isolation between the electrical contact and the rest of the structure.

In a subsequent cladding step 320 the backbone structure 100 including the dome 304 is cladded or metalized with a conductive cladding material 302. As can be seen this cladding step may form an electric connection between the electric interconnection 205 and the conductive material 302 on rest of the structure.

In a subsequent filling step 330 the backbone structure 100 including the dome 304 is filled by an insulating material 303, e.g. a heat conducting and electrically isolating mould-compound. This insulating material 303 embeds the electric interconnections 205 and serves a function of support and sturdiness for the cladded structure. In particular it provides a secondary support for the interconnections when the primary support formed by the protruding features 306 (the dome and connection rod) are removed in the following step.

In a subsequent isolating step 340 and exposing step 350, the electric interconnection 205 is electrically isolated from the conductive material 202 on and the rest of the structure and a part of the conductive material on the interconnection 205 is exposed to provide an external contact 203. In particular this is done by removing the dome (e.g. through grinding or milling) from the face of the container thereby severing the cladded connection rod 305 and exposing the part of the conductive material of the electric interconnection 205 that was formed from the corresponding cladding skeleton part 105.

In an advantageous embodiment the ending comprises a widening and/or parallel surface near the contact position 103 for increasing a contact pad of the electric contact 203 that will be formed from this part. In a further advantageous detail the top of the parallel surface at the contact position 103 is substantially at the same height 333 as the face 102 from which the dome 304 protrudes. This detail will mean that if the dome 304 will be removed until the height 333 of the face 202 of the interposer this will exactly lay bare the parallel contact pad of the electric contact.

In a further advantageous embodiment a protruding part 306 of the metalized or cladded dome is mechanically removed e.g. through grinding or milling, until just above (e.g. within 10 micrometers of) the electric contact 203, e.g. for severing the support rod 305 and electrically isolating the electric interconnection 205 from the other conductive material 202. This may leave a small amount of insulating material 303 in an area 307 above the contact 203. In a further advantageous embodiment, the insulating material 303 can be chemically removed, e.g. by selective etching, for exposing the conductive material on an electric interconnection 205 for forming an electric contact 203. In particular a combination of an insulating material 303 and etching agent can be selected that react with each other while not affecting the conductive material 302. In this way e.g. the grinding step needs less precision and the contact 203 can be exposed without inadvertently damaging the contact during the grinding step.

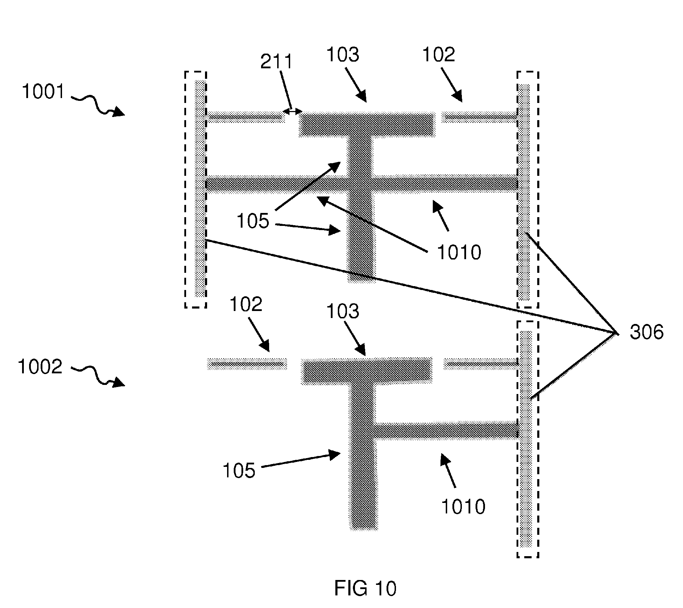

It is to be understood that although a round dome is shown in the illustrations, the shape could also be different, e.g. a square-shaped dome or almost any hollow and/or protruding shape such as an arch, without affecting the currently demonstrated principle of isolating and/or exposing the contacts 203 by removing the protruding shape. In particular a hollow dome has an advantage that an underlying contact pad can be metalized, embedded in insulating material and then exposed to form the electric contact. Further it is understood that instead of a single support rod 305, there can also be multiple connection rods and/or further support parts, e.g. if this helps in the support of the cladding skeleton part 105. Also the dome structures 304 and/or support rods 305 can be part of a support connection that does not form an electric interconnection itself but helps to support an electric interconnection 205 (e.g. supporting the electric interconnection somewhere in between two contacts 203 such as illustrated in FIG 10).

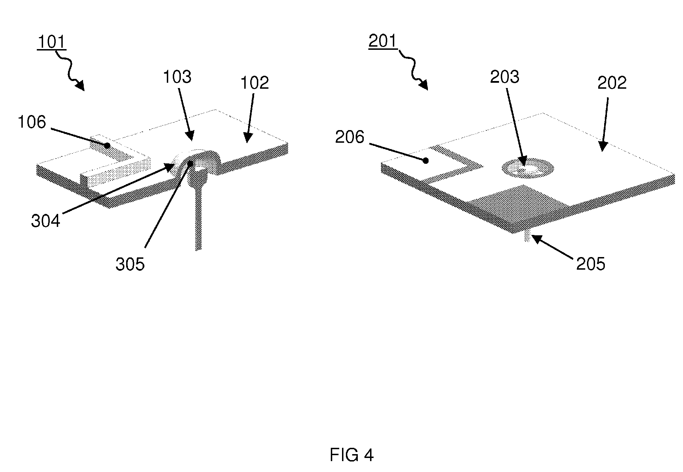

FIG 4 shows a cross-sectional view of a dome structure 304 and an electric contact 203 of an electric connection 205 that is created after removing the dome structure 304. In particular it may be observed that the electric contact 203 is electrically isolated from the conductive material 202 on the container by severing the support rod 305. Further shown is how a ridge 106 on an outside of the container 101 can result in an external conductive patch or external electric connection 206 on a face of the support structure 201.

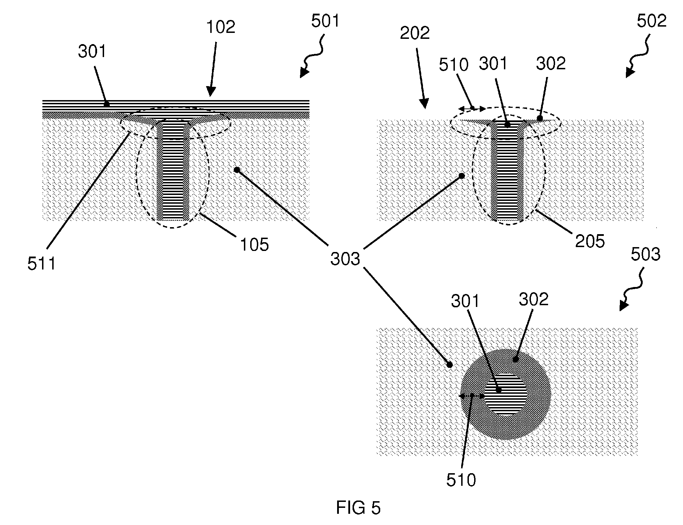

The dome structure provides a convenient method wherein only the domes need to be removed and it is not necessary to grind the entire (metalized) outer surface away. E.g. it is not necessary to grind most of the conductive layer off the surface for isolating conductive pathways embedded in the surface. Even if parts of the metalized outer surface have no function as electric conduits, they can serve a purpose e.g. of heat dissipation. FIG 5 shows cross sections before 501 and after 502 milling of an advantageous embodiment of a cladding skeleton part 105 ending in a widening cross-section or diameter 511 near a surface 102 of the container. Top view 503 of the after picture 502 shows the conductive material 302 externally visible on the surface of the structure. The conductive material 302 of the electric contact encloses the cladding skeleton material 301 and is surrounded by the insulation material 303. In this embodiment an increased electrical contact surface 510 is created by constructing in the additive layer-wise manufacturing process a cladding skeleton part 105 with a trumpet-like widened shape 511 near a face 102 of the container. In particular, the more sloped the shape 511 is (more parallel to the surface 102) the higher will the contact surface 510 be.

FIG 6 shows a schematic example of a layer-wise manufacturing process 310. In the example, a layer of radiation curable material 301, e.g. in liquid form or in a foil, is provided and illuminated with a predetermined pattern 602 of radiation corresponding to a pattern of the layer of the backbone structure 100 that is to be created. This radiation cures or solidifies the radiation curable material or liquid, forming a layer 601 (indicative layer thickness e.g. 1 - 2 micrometers) of the backbone structure. In such a way the backbone structure 100 is created by adding layer upon layer.

In the example a cross section of the backbone structure 100 is shown comprising a container 101 with inside cladding skeleton parts 105 ending in a support rods 305 and dome structures 304. In the shown embodiment the backbone structure 100 rests on a platform 604 and is created bottom to top. In another embodiment, the backbone structure can be created top to bottom, diagonal or along any other plane of intersection. Instead of the platform 604, the structure can also be hanging from a support point 108 as was shown in FIG 1 (e.g. hanging in a bath of liquid radiation curable resin). The predetermined pattern 602 of radiation can be provided e.g. by a digital lighting projection (DLP) system 603 with individual lights or light guiding means that project the pattern on the layer of radiation curable material 301.

An additive layer-wise manufacturing process 310 contrasts with conventional lithographic processes wherein a layer, e.g. a circuit, is etched away in a pattern corresponding to a mask. The mask does not have to be created and it is not necessary to continuously add layers and then remove parts of those layers to form a desired pattern.

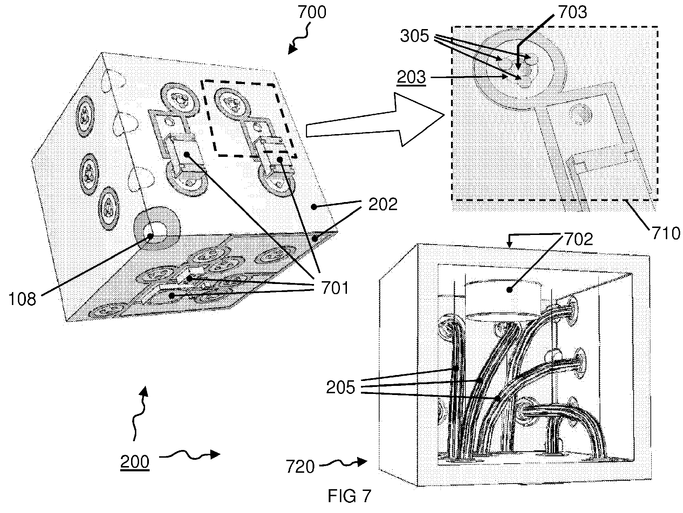

FIG 7 shows two views 700, 720 and a detailed zoom-in 710 of another embodiment of an interposer 200 created according to the above mentioned methods.

In the view 700 the interposer 200 is shown with micro-electronic devices 701 such as semi-conductor chips on the faces 202 of the support structure. These devices or chips could be any (integrated) device or chip that has input/output connections that fit with the electric contacts 203 of the interposer.

In the detailed zoom-in 710 of view 700, it is shown that the contacts 203 can comprise a small insertion 703 plated with conductive material. Such an insertion 703 can be useful e.g. for more easily connecting contact legs (not shown) of a semiconductor chip 701. The insertion 703 can be manufactured during the layer-wise manufacturing process and cladded in a subsequent cladding step. As is shown in the embodiment, the insertion is surrounded by three cut-off support rods 305. As discussed above, these support rods 305 form a connection to a dome structure (see e.g. FIG 3) during the layer-wise manufacturing and cladding process. Because there is enough room between the support rods 305 and because the insertion 703 is relatively shallow the cladding material can reach the intended inner surfaces of the insertion 703.

Advantageously these insertions 703 can be used in combination with flip chips or a method known in the art as 'controlled collapse chip connection' (C4). This C4 method can be used for interconnecting semiconductor chips to the interposer with for instance solder bumps that are deposited on the chip pads on the top side after which the chip is flipped over to mount it to the interposer. The pads or legs are then aligned with matching pads or insertions on a face of the interposer and the solder can be flowed to complete the interconnection. Another method for connecting the semiconductor chips is e.g. wire bonding, wherein the chip is mounted upright, and wherein wires are used to interconnect the chip pads to the interposer contacts.

In the back-view 720, the inside of the interposer 200 is shown (without insulating material), including the electric interconnections 205 and a screw hole connection 702 (hole not shown) that can be used to e.g. attach the interposer to a support bolt. Advantageously the electric interconnections 205 have been provided with a ribbed or grooved structure wherein the ribs or grooves of said structure run substantially parallel along the length of the interconnection 205. The ribbed interconnections 105 e.g. have a cross-section that is substantially star-shaped. This offers e.g. an advantage of increasing a surface of the interconnection 205 without significantly adding to the average path length of the electric interconnection (which would be the case if the interconnections were simply roughened). The increased surface not only helps in the cladding process (by increasing the surface to which the cladding material can adhere) but can also be beneficial for e.g. increasing a conductivity of the electric interconnection.

In an alternative embodiment the cladding skeleton parts 105 are provided with a hole structure (not shown) of through-holes or indents provide a larger volumetric ratio of the cladded conductive material over the non-conductive skeleton parts formed in the layer-wise manufacturing process. This thus provides a higher conductivity of the electric interconnections.

Finally, in the shown embodiment a support point 108 is located on a corner of the interposer 200. This support point 108 could be used e.g. to hang the backbone structure during the layer-wise manufacturing process. In an advantageous embodiment the backbone structure is constructed in a diagonal direction with respect to the faces 102. This can be advantageous to prevent any floating or non-supported parts during the layer-wise buildup of the backbone structure. In another advantageous embodiment the backbone structure 100 is built with the help of a computer algorithm which is used to determine an optimal buildup direction such that there are no floating parts in the layer-wise buildup of the backbone structure.

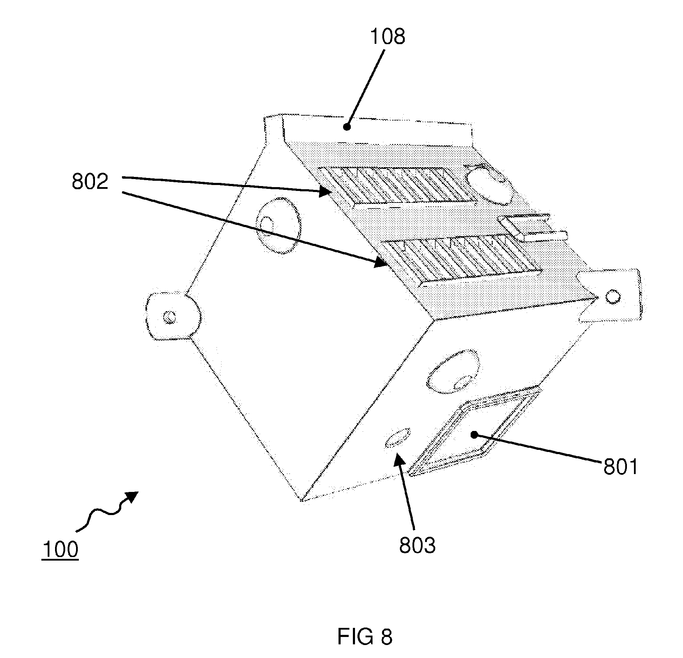

FIG 8 shows additional features on another embodiment of a backbone structure 100, prior to grinding or milling. In particular the embodiment shows a support point 108 in the form of a rib, from which the shown backbone structure 100 was grown. Other features include structures for providing a cooling plate 801 and cooling fans 802. These structures (plated with a conductive material) may provide additional thermal transport, e.g. of heat generated inside the electric or conductive wires 205 in the interposer. Furthermore a thermal via 803, which is an outside hole in the container may provide a similar function.

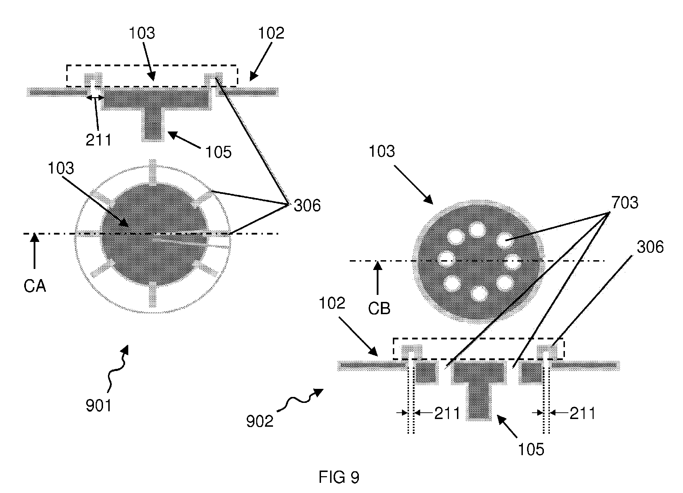

FIG 9 shows two embodiments 901 and 902 of protruding arches 306 or a protruding rim 306, respectively, supporting the ending of a cladding skeleton part forming the electric contact 203 to a face 202 of the support structure. A top view of the structures is shown as well as a cross-sectional view along the cross-section lines CA and CB of the embodiments 901 and 902, respectively.

The embodiment 901 comprises a flat contact pad at the contact position 103 which is shown to be supported by a protruding connection part 306 (a plurality of arches) to a face 102 of the support structure. In the embodiment 902 the protruding connection part 306 comprises a protruding overarching rim that connects to the contact pad 103. This contact pad 103 further comprises a plurality of insertions or vias 703 that will form convenient electrical contact points e.g. for flip chip connections as mentioned above with FIG 7.

The connection part 306 comprises one or more protruding (arch) structures that form a bridging connection over a separation 211 between the ending 103 of a cladding skeleton part 105 and the face 102 of the support structure. In a subsequent isolating step the protruding connection parts 306 are removed, optionally, after a secondary support is provided (e.g. an insulating filling material or other secondary support structures). In this way, cladding material or cladded support parts of the support structure are partially removed after the cladding step (320). In particular, cladding is removed that electrically interconnects the face 102 with a skeleton part (e.g. the contact 103) thereby electrically disconnecting the cladded skeleton parts 105 from each other. It is noted that the removal step can be skipped if no electric connection is provided between cladded skeleton parts and the cladding is performed while the skeleton parts remain electrically disconnected. This may be realized by selective cladding, for example, a cladding step wherein a connecting part of a support face is not cladded, for example, by selective cladding or by suitable preparation of the connecting part to prevent cladding.

It is to be appreciated that the currently shown embodiments 901 and 902 could also be combined with the dome structures 304 shown e.g. in FIG 3 instead of or in combination with the currently shown protruding arches 306. A support rod 305 such as shown in FIG 3 could e.g. be used to support the contact pads from the dome structure 304. Furthermore a selective etching step as also discussed with FIG 3 could be used to expose the contact pads e.g. of any insulating material.

FIG 10 shows two embodiments 1001 and 1002 of internal support parts 1010 supporting a cladding skeleton part 105. Embodiment 1001 has two support parts 1010 supported on two walls 306 while embodiment 1002 has one support part 1002 that connects to one wall 306. The support parts 1010 form a support structure supporting the cladding skeleton parts 105. Support parts 1010 can be cladded during the cladding procedure since they do no provide an electric connection between contact positions 103. To electrically isolate the cladded cladding skeleton parts 105 from the rest of the structure, the walls 306 that electrically connect to the cladded cladding skeleton parts 105 can be removed, e.g. by grinding or milling until a cladded internal wall of the has been removed. This is thus similar to the removal of protruding parts except that the face on which the removal takes place has in this case no contact positions. Optionally, prior to the removal of the supporting walls 306 it is advantageous to provide the cladding skeleton parts with a secondary support such as insulating foam that embeds and supports the cladded cladding skeleton parts.

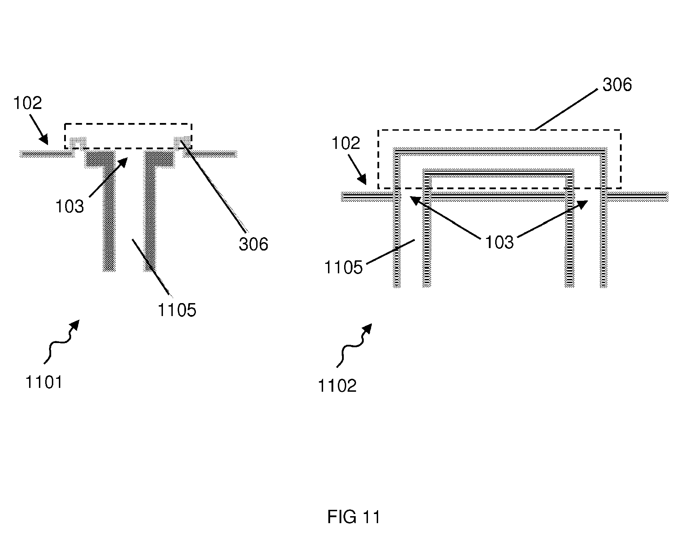

FIG 11 shows two embodiments 1101 and 1102 wherein an interconnection or cladding skeleton part comprises a hollow tube 1105 that runs between contact positions 103. An electric interconnection can be formed by flushing a plating fluid through the hollow tube 1105, thereby cladding or filling an inside of the tube 1105. Hollow tubes 1105 may have a freeform shape and diameter to optimize fluid flow of the plating fluid through the tubes. In particular, the diameter can be adjusted to prevent inadvertent blocking of the tubes in an interior part. Another advantage of cladding a hollow tube 1105 on the inside is that the interconnections are not electrically connected to the rest of the support structure holding the cladding skeleton. This allows e.g. the possibility to construct thermal vias connecting to an inside of the container.

Embodiment 1101 is connected by arching structures 306 to the face 102 of the support structure. This allows also the exterior of the hollow tube to be cladded if these protruding arches are later removed.

In an alternative embodiment 1102, the hollow tube 1105 can form multiple interconnections between a plurality of contact positions 103. The hollow tube 1102 e.g. could cross the face 102 of the support structure at the various contact positions 103 before looping back in a protruding part of the tube 306 and continuing with another interconnection starting from another contact position 103. Conveniently the hollow tube thus forming a plurality of interconnections can be flushed by a plating fluid from one end of the tube 1105 all the way through to the other end of the tube 1105. The protruding parts of the tube 1105 can be grinded or milled away similar the protruding arches or domes discussed before. This will simultaneously isolate the individual electric interconnections and expose the cladded material at the contact positions 103.

The various elements of the embodiments as discussed and shown offer certain advantages, such as providing an interposer with smaller electric interconnections, increased flexibility in the design, and an generally easy to produce interposer. Of course, it is to be appreciated that any one of the above embodiments or processes may be combined with one or more other embodiments or processes to provide even further improvements in finding and matching designs and advantages. It is appreciated that this invention offers particular advantages for interposers of semiconductor chips, and in general can be applied for any type of three-dimensional integrated interconnect structure forming a support and electric interconnection between chips, integrated circuitry, or simple components such as light emitting diodes (LEDs), or e.g. combinations of cooperating circuitry such as a receiver, a processing chip, and a power supply. The interposer typically has a limited number in the order of 2-20 of microelectronic devices to provide a complex microelectronic device. Other interconnect structures may include fine pitched connecting PCBs, for connecting packages of Surface Mounted Device chips or as the case may be bare die chips.

Finally, the above-discussion is intended to be merely illustrative of the present system and should not be construed as limiting the appended claims to any particular embodiment or group of embodiments. Thus, while the present system has been described in particular detail with reference to specific exemplary embodiments thereof, it should also be appreciated that numerous modifications and alternative embodiments may be devised by those having ordinary skill in the art without departing from the broader and intended spirit and scope of the present system as set forth in the claims that follow. The specification and drawings are accordingly to be regarded in an illustrative manner and are not intended to limit the scope of the appended claims.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise; no specific sequence of acts or steps is intended to be required unless specifically indicated; and no specific ordering of elements is intended to be required unless specifically indicated.

## Claims

1. Method for producing a three-dimensional interconnect structure (200) comprising one or more electric interconnections (205) ending in externally addressable electric contacts (203) on one or more connection faces (202) of the interconnect structure (200) for electrically interconnecting micro-electronic devices (701) connected to said one or more connection faces (202), wherein the method comprises the steps of
- constructing through an additive layer-wise manufacturing process (310) a backbone structure (100) comprising
o a three-dimensional cladding skeleton (104) comprising layered freeform skeleton parts (105) forming freeform interconnections between corresponding contacts (203), said contacts (103) arranged in the connection faces (202); and
o a connected support structure (101) of layered support parts (304) that support and connect the cladding skeleton parts (105);
- cladding (320) the cladding skeleton (104) with a conductive cladding material (302); and
- electrically disconnecting (340) cladded skeleton parts (105) from each other thereby creating electric interconnections (205) of the interconnect structure (200) along the cladded skeleton parts (105) between the corresponding contacts (203).

2. Method according to any of the previous claims, removing, after the cladding step (320), connecting support parts (304) or at least a cladding thereon, thereby electrically disconnecting the cladded skeleton parts (105) from each other.

3. Method according to any of the previous claims, further comprising the step of embedding (330) the cladded skeleton (104) in an electrically insulating material (303), wherein a cladded part of the layered freeform skeleton part (105) is exposed to form the electric contact (203).

4. Method according to claim 3, wherein
— a support part (304) of the support structure is connected to said connection face (102) and protrudes there from; and
— said protruding support part (304) is removed after the insulating material (303) is provided thereby electrically disconnecting the cladded skeleton parts (105) from each other.

5. Method according to claim 4, wherein the protruding support part comprises a hollow dome and/or arch structure (304) that forms a bridging connection over a separation (211) between an ending of a cladding skeleton part (105) and the face (102) of the support structure (101).

6. Method according to claim 4 or 5, wherein the protruding support part (304) is removed in a milling or grinding process.

7. Method according to any of the claims 4 - 6 wherein said face (102) of the support structure (101) is part of an at least partially closed hollow container (101) that at least partially encloses the cladding skeleton (104) and can be used for holding the insulating material (303.

8. Method according to claim 7, wherein the hollow container (101) comprises one or more external accesses (107) to the inside of the container (101) and wherein the cladding skeleton (105) is cladded through one or more external accesses (107).

9. Method according to claim 7 or 8, wherein the container (101) further comprises ridges (106) forming a trough on an outside face (102) of the container that will form an electric interconnection (206) on an outside face (202) of the support structure (201); said trough and ridges (106) are cladded during the cladding step (320); and said ridges (106) are at least partially removed to isolate the electric interconnection in the trough on the outside face of the support structure (201).

10. Method according to any of the previous claims, wherein an externally addressable electric contact (203) is provided with an increased electrical contact surface (510) by constructing in the additive layer-wise manufacturing process (310) a cladding skeleton part (105) with a widening cross-section (511) and/or a parallel surface near the connection plane (102).

11. Method according to claim 1, wherein the additive layer-wise manufacturing process (310) comprises repeatedly the steps of
- providing a layer of radiation curable liquid; and
- performing a solidifying step wherein a layer (601) of the backbone structure (100) is formed, the solidifying step carried out by illuminating said layer of radiation curable liquid with a predetermined pattern (602) of radiation corresponding to a pattern of the layer of the backbone structure (100).

12. Method according to any of the previous claims, wherein the cladding skeleton parts (105) form a single connected tube that is cladded on an inside surface by flushing a plating fluid trough the tube for forming the electric interconnections (205).

13. A three-dimensional microelectronic device interconnect structure (200) comprising
- a connect structure (201) with faces (202) for connecting microelectronic devices (701) connectable to said faces (202);
- a plurality of electric contacts (203) that are externally addressable on said faces (202); and
- a plurality of electric interconnections (205), the electric interconnections (205) ending in two or more of the electric contacts (203) for electrically interconnecting the microelectronic devices (701), wherein
- the electric interconnections (205) are provided as layered freeform skeleton parts (105) and cladded by a conductive material (302).

14. Interconnect structure (200) according to claims 13, wherein at least one layered freeform skeleton part (105) follows a freeform path between corresponding contacts (203) arranged in the connection faces (202) wherein said path has over at least a portion of its trajectory a direction that is non-parallel and non-perpendicular with respect to any face (202) of the interposer (200).

15. Interconnect structure (200) according to any of the claims 13-14, wherein the support structure (201) has at least two non parallel faces (202) comprising electric contacts (203).

16. Interconnect structure (200) according to any of the claims 13-15 wherein the layered freeform skeleton parts (205) are ribbed, grooved or selectively indented with ribs or grooves or indents along a length of the skeleton parts (205).
